# FASCICULE DE BREVET EUROPEEN

(11) **EP 0 489 643 B1**
(45) Date de publication et mention de la délivrance du brevet: **01.03.1995**
(21) Numéro de dépôt: 91403267.7
(22) Date de dépôt: 03.12.1991
(51) Int. Cl.: H01L 25/18, H01L 25/065

(54) **Modules de mémoire à état solide et dispositifs de mémoire comportant de tels modules**
Festkörper-Speichermodule und Speicheranordnungen mit solchen Modulen
Solid state memory modules and memory devices having such modules

(30) Priorité: 05.12.1990 FR 9015210
(43) Date de publication de la demande: 10.06.1992
(73) Titulaire: MATRA MARCONI SPACE FRANCE, 75116 Paris (FR)
(72) Inventeur: de Givry, Jacques, F-78350 Les Loges en Josas (FR)
(74) Mandataire: Fort, Jacques

(56) Documents cités:
- EP-A- 0 222 203
- DE-A- 1 639 309

## Description

L'invention concerne le domaine des dispositifs de mémoire utilisés dans les systèmes informatiques et notamment les mémoires à grande capacité.

Les besoins en capacité de mémoire des systèmes informatiques ne cessent d'augmenter. Dans beaucoup de cas, l'espace disponible doit être aussi réduit que possible. Ces besoins ont conduit à développer des composants unitaires de plus en plus intégrés : les composants de mémoire vive atteignent en 1990 des capacités de 1 Mbit en statique, 4 Mbits en dynamique. Ils ont également conduit à développer des procédés d'interconnexion permettant de fortes densités de montage des puces. Pour augmenter encore la capacité dans un volume donné, on a proposé des modules de mémoire comprenant, sur un substrat d'interconnexion, un empilement constitué de plusieurs puces superposées. On réalise ainsi une répartition dans l'espace et non plus simplement dans le plan. Mais on se heurte à des problèmes d'interconnexion entre puces et surtout entre les puces et le substrat qui conduisent à des processus itératifs onéreux et longs. Il faut en effet, du fait que les puces sont exactement superposées, effectuer les liaisons sur la puce la plus basse, placer un intercalaire, coller la puce qui est au-dessus, câbler cette nouvelle puce et ainsi de suite.

On a également proposé (Patent Abstracts of Japan, Vol. 11, N° 148 (E 506, 14 Mai 1997) et (JP-A-61 287 133) un empilement de plusieurs puces, à savoir une mémoire de masse, un processeur et une mémoire de programme. Ces puces ont des dimensions décroissantes depuis le substrat jusqu'à la dernière puce qui est la mémoire de programme. Cette mémoire de programme, plus petite que les autres, est placée transversalement aux deux autres qui sont allongées dans le même sens. Du fait des dimensions différentes des trois puces, on peut les interconnecter. Ce n'est pas là le but de l'invention qui vise à faciliter l'interconnexion entre différentes mémoires de même dimension et le substrat d'un module mémoire. Deux puces successives sont toujours croisées entre elles. Ce n'est pas la même disposition que décrit le document JP, où les deux puces inférieures sont orientées de la même façon.

La présente invention vise à augmenter les densités d'implantation couramment utilisées à l'heure actuelle, par une répartition en volume et non plus en plan, sans pour autant rencontrer les problèmes d'interconnexion auxquels se heurtent les solutions déjà envisagées. Elle utilise dans ce but la constatation que la plupart des puces de mémoires à grande capacité existantes ont une forme rectangulaire très allongée et que les connexions de sortie de ces puces sont souvent localisées aux deux extrémités. A titre d'exemple, la puce HC 628-128 de mémoire 1 Mbit a une longueur L et une largeur l qui sont respectivement de 14,4 et de 5,7 mm, avec seize plages de raccordement à chaque extrémité. L'invention propose en conséquence un module de mémoire suivant la revendication 1.

Grâce à ce croisement, les connexions à partir des deux extrémités des puces s'effectuent sans aucune difficulté, puisque les liaisons à partir de la puce supérieure ne sont pas gênées par la puce inférieure. En apparence, le montage en croix de deux puces ne fait pas gagner d'espace. Mais en fait il est toujours nécessaire d'associer aux mémoires des composants annexes de plus petite dimension, tels que des condensateurs et/ou des circuits logiques intégrés. Ces composants de petite taille peuvent être placés entre les branches de la croix.

Lorsque les puces sont suffisamment allongées, trois puces peuvent être croisées à 60° les unes des autres.

Qu'on utilise deux puces ou trois puces croisées, il est souhaitable de placer des cales sous les extrémités des puces, afin d'éviter un porte-à-faux lors de l'appui de l'organe de soudure des fils d'aluminium ou d'or aux plages terminales.

Sur deux puces empilées et croisées peuvent être superposés d'autres jeux de deux puces, chaque fois en plaçant des cales destinées à éviter les portes-à-faux.

Un mode avantageux de réalisation de l'invention, applicable lorsque chaque puce a une longueur supérieure à deux fois sa largeur est défini par la revendication 5. Cette disposition permet d'augmenter considérablement la compacité.

La revendication 10 décrit un dispositif comprenant plusieurs modules de mémoire selon l'une quelconque des revendications 1 ou 5.

L'invention sera mieux comprise à la lecture de la description qui suit de modes particuliers de réalisation de l'invention, donnés à titre d'exemples non limitatifs. La description se réfère aux dessins qui l'accompagnent, dans lesquels :
- la figure 1 est un schéma de principe en élévation montrant un micro-module constitué de deux puces de mémoire sur un substrat ;
- la figure 2 est une vue en élévation montrant la juxtaposition de deux couples de puces, les deux puces de chaque couple ayant la disposition montrée en figure 1 ;
- la figure 3 montre schématiquement un module comprenant trois puces croisées à 60° ;
- la figure 4, similaire à la figure 1, montre un mode particulièrement avantageux de mise en oeuvre de l'invention ;
- la figure 5 montre un dispositif de mémoire comportant quatre micro-modules du genre montré en figure 4 ;
- la figure 5A est un schéma en perspective montrant comment les plages des puces d'un micro-module du genre montré en figure 5 peuvent être raccordées à un bus prévu sur un support ;
- la figure 6 montre un dispositif comportant un support double face ;
- la figure 7, similaire à la figure 6, montre un mode possible de montage en boîtier hermétique ;
- les figures 8 et 9, similaires à la figure 6, montrent des variantes de réalisation ;
- la figure 10 est un schéma de principe montrant un mode possible de montage de micro-modules avec raccordement avec une carte mère.

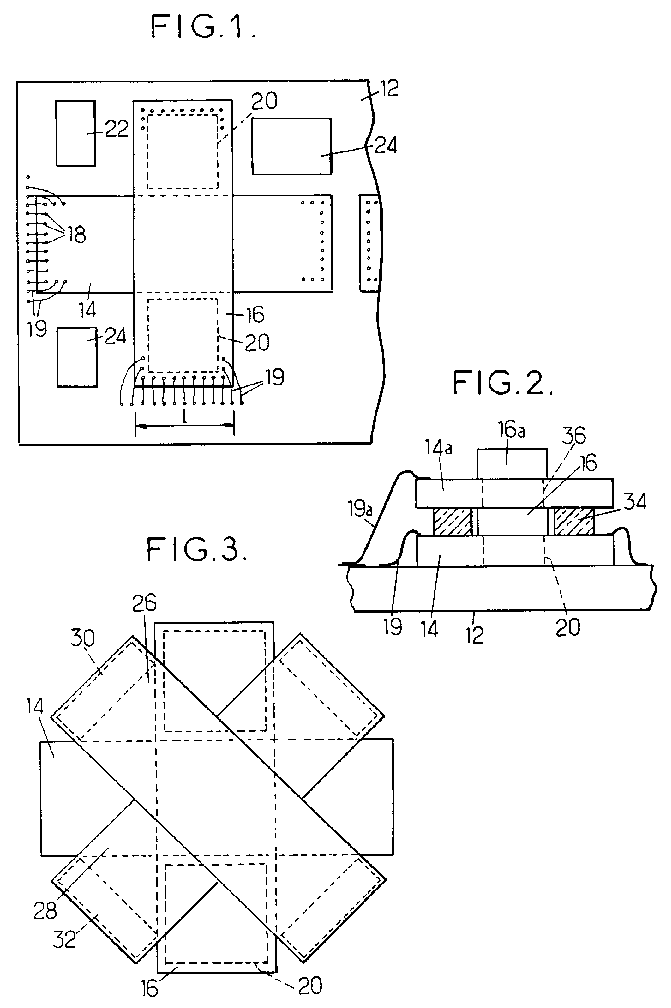

Le micro-module montré schématiquement sur la figure 1 comporte un substrat porteur 12 et deux puces de mémoire 14 et 16, de forme allongée. La puce 14 est directement collée sur le substrat 12, qui est par exemple un substrat en céramique portant un circuit hybride. Les plots de sortie 18 de la puce 14 sont raccordés à des pistes formées sur le substrat porteur 12 par des fils 19, généralement en aluminium ou en or, fixés par soudage thermosonique ou par thermocompression. La puce 16 est collée en croix sur la puce 14 et ses plots de sortie sont également reliés aux pistes du substrat porteur 12 par des fils 19, qui auront une longueur plus grande que les fils de raccordement des plages 18. Un tel collage à l'aide de résine isolante époxyde ou silicone est possible sans aucune corrosion des puces, dont la surface est passivée dans la zone encollée. Pour éviter un porte-à-faux intempestif lors de l'application de la sonde de soudage, des cales 20 de même épaisseur que la puce 14, donc très minces (en général moins de 0,3 mm) sont intercalées sous les parties terminales de la puce 16. On utilisera généralement des cales en silicium, qui pourront être des fragments de puces mises au rebut.

La mise en place de la puce 14 et des cales 20, puis de la puce 16, peut s'effectuer par une machine automatique à l'heure actuelle disponible.

Dans les zones mortes qui subsistent entre les branches de la croix formée par les puces 14 et 16 peuvent être disposés des composants de petite taille, tels qu'un condensateur 22 et des logiques associés 24, tels que registres tampon, circuits de couplage, etc...

Comme le montre la figure 2, on peut empiler deux jeux de puces du genre montré en figure 1, ce qui permet un gain de place supplémentaire. La puce 14a placée au-dessus de la puce 14 en est séparée par la puce 16 et par des cales 34, qui doivent laisser alors subsister un léger porte-à-faux pour laisser de la place aux soudures des fils 19 et ne pas écraser ces fils. Il en est de même des cales 36 interposées entre les puces 16a et 16.

Le nombre de jeux de deux puces que l'on peut ainsi empiler est limité notamment par les modes habituels de montage automatique : les machines à soudage thermosonique n'acceptent qu'une dénivelée limitée entre les soudures d'extrémité d'un même fil. On voit sur la figure 2 que la dénivelée entre les soudures terminales d'un fil 19a est déjà nettement supérieure à la dénivelée entre les soudures d'un fil 19.

Une autre limitation du nombre de jeux est liée au caractère itératif du processus de montage : alors que dans la figure 1 une seule séquence de soudage suffit, deux séquences sont nécessaires dans le cas de la figure 2, puisqu'il faut successivement placer le premier jeu et faire les soudures, puis coller les puces du second étage avant d'effectuer une nouvelle opération de soudage.

Lorsque les puces de mémoire ont un rapport longueur (L) largeur (l) suffisant, il est possible de croiser plus de deux puces, pour permettre de câbler en une seule opération un nombre plus élevé de puces disposées en étoile. On a notamment utilisé trois puces à 60° l'une de l'autre. On peut également placer en étoile quatre puces 14, 16, 26 et 28, comme le montre la figure 3. Dans ce cas, des cales de dimension et d'épaisseur différentes 20, 30 et 32 doivent être prévues. Les puces et les cales sont d'abord assemblées par collage, puis le câblage est effectué comme dans le cas de la figure 1.

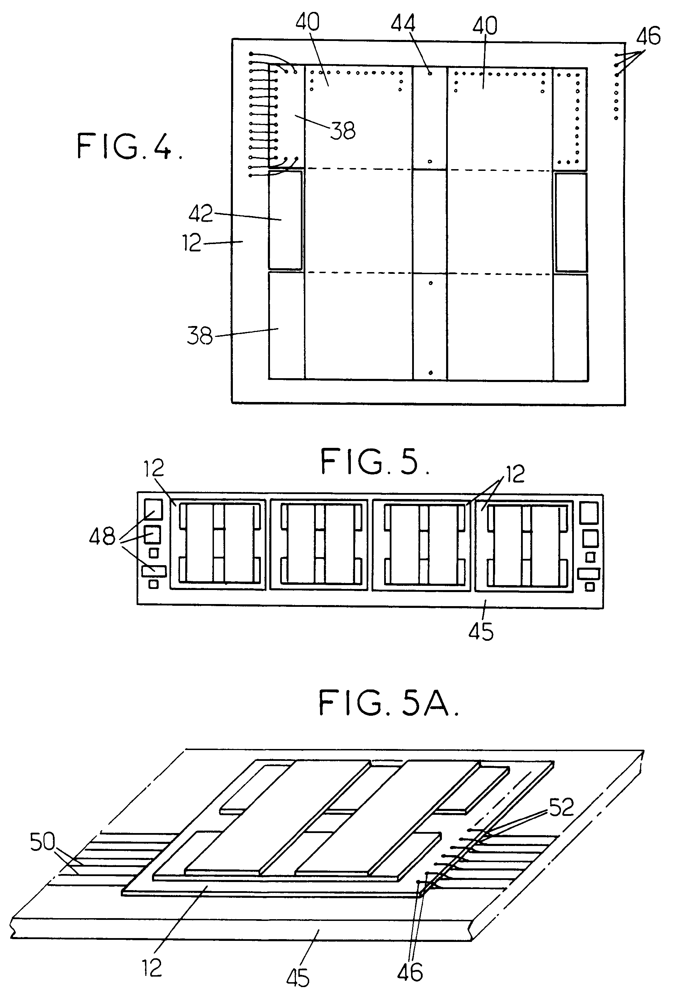

La figure 4 montre un mode de réalisation de l'invention particulièrement avantageux par le gain de place qu'il procure et l'absence de porte-à-faux. Le micro-module montré en figure 4 comporte une paire de puces inférieure 38 et une paire de puces supérieures 40. Les deux puces de chaque paire sont disposées parallèlement l'une à l'autre et croisées avec les deux puces de l'autre paire. Les puces 38 sont collées directement sur le substrat et leur écartement est tel que les parties terminales des puces 40 s'appliquent sur elles, évitant un porte-à-faux. Des cales 42 peuvent être placées entre les puces 38 pour garantir une mise en place relative précise. L'écartement des puces 40 est tel qu'elles libèrent les parties terminales des puces 38 et notamment les plots de raccordement des fils 19. Ce montage autorise également l'emploi de puces présentant des plots de sortie 44 dans leur zone médiane.

Dans le dispositif montré en figure 4, la densité d'intégration est pratiquement doublée par rapport à celle d'un montage normal.

Il est possible de constituer un micro-module indépendant, testable individuellement, interchangeable avec un autre micro-module, en utilisant un substrat 12 de petit format, toutes les connexions d'interface du micro-module étant ramenées d'un seul côté du module, sur des plots de sortie 46, par des pistes imprimées.

Plusieurs micro-modules du genre montré en figure 4 peuvent être montés sur une seule face ou sur les deux faces d'un support de plus grande taille, de type co-cuit, ou portant des circuits en couche épaisse. La figure 5 montre quatre micro-modules ayant chacun un substrat 12, fixés sur un support 45 portant des circuits d'interconnexion réalisés par exemple en technologie à couche épaisse. Le support 45 peut porter également des composants annexes 48.

Dans un module du genre montré en figure 5, les connexions peuvent être rendues particulièrement simples en prévoyant sur le support 45 un bus passant sous les substrats 12. Les plages de connexion des substrats sont alors reliées aux fils de bus par des trous métallisés des substrats. Les liaisons avec les conducteurs de bus 50 peuvent également être effectuées à l'aide de tronçons de fils soudés 52, comme indiqué schématiquement sur la figure 5A.

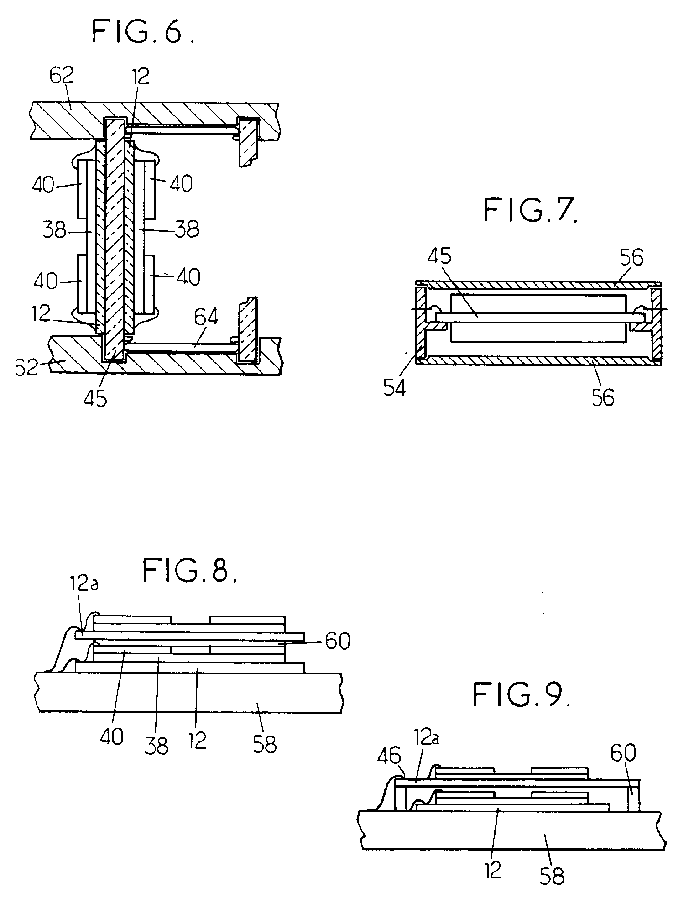

Un support 45 peut être muni de micro-modules sur ses deux faces, comme indiqué sur la figure 6. On peut ainsi constituer des modules portant quatre micro-modules sur chaque face et correspondant à une mémoire organisée en octets. Un tel module peut être placé dans un boîtier métallique comportant un cadre 54 et des couvercles scellés 56, comme indiqué sur la figure 7. Le support peut être un des substrats bi-face dits "multi chip modules" en cours de commercialisation dont les deux faces sont reliables par des liaisons à l'intérieur du support.

Dans une autre disposition possible, illustrée sur la figure 8 deux micro-modules ayant chacun la constitution montrée en figure 5 sont superposés sur un support 58. Les deux micro-modules sont alors identiques, mais une cale intercalaire 60 doit être prévue entre pour eux pour éviter de coucher les fils de connexion du micro-module inférieur. Une autre solution, schématisée en figure 9, consiste à utiliser un micro-module supérieur dont le substrat support 12a a une taille en plan supérieure à celle du substrat support 12 du micro-module inférieur de façon qu'il puisse reposer sur une cale 60 en forme de cadre. La cale 60 a alors une épaisseur réservant un jeu de passage des fils entre le micro-module inférieur et le substrat 12a.

Dans le cas illustré en figure 9, un substrat porteur pourra être orienté à 180° de l'autre et prévu pour que sa rangée de plots de connexion externe 46 corresponde aux emplacements d'un bus rectiligne sur le support 58.

Plusieurs modules du genre montré en figure 6 peuvent être juxtaposés parallèlement dans un cadre ou boîtier métallique portant une carte mère pour constituer un dispositif de mémoire. La figure 6 montre les flancs 62 d'un tel cadre, munis de rainures dans lesquelles s'engagent les supports 45. L'écoulement de la chaleur générée par les circuits est assuré par appui des bords des supports 45 contre la paroi des rainures par des ressorts 64. La carte mère, non représentée, est prévue au fond du cadre.

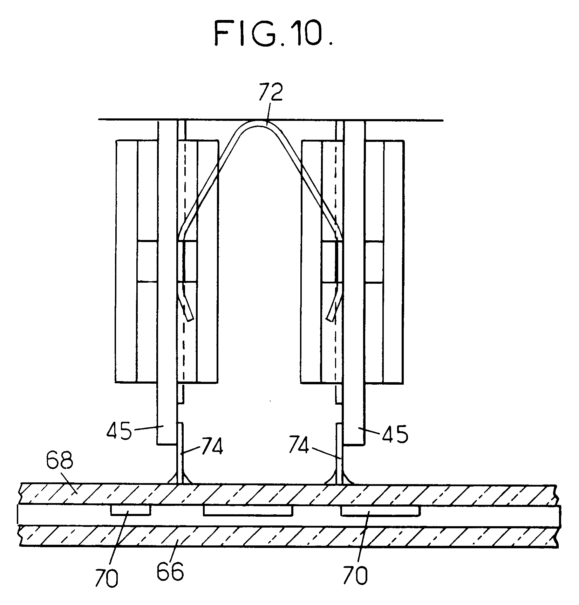

La figure 10 montre un dispositif qui constitue une variante de celui de la figure 6. Le fond 66 du cadre porte la carte mère 68, équipée éventuellement sur sa face arrière de composants tels que des mémoires ou jeux de bascules tampons, des condensateurs, etc... 70. Les supports 45, portant chacun un jeu de quatre puces sur chaque face, sont encore guidés par des rainures non représentées. Des ressorts en épingle 72, emprisonnés dans des logements du cadre, pressent les bords des supports contre la paroi des rainures et garantissent un bon contact thermique. Les supports 45 sont munis de rangées de pattes de sortie 74 de même longueur fixées aux supports, par exemple par soudage à haute température ou soudage électrique à pression. Les pattes de sortie 74 viennent en contact avec la carte mère 68, constituée généralement en circuit couche épaisse ou en co-cuit céramique du type couramment désigné par l'abréviation anglo-saxonne "multi-chip module". Cette carte est préalablement étamée localement, aux emplacements d'appui des sorties 74. Les pattes de sortie 45 peuvent ensuite être solidarisées des zones étamées en une seule opération de refusion, par exemple en phase vapeur.

L'ensemble ainsi constitué peut être enfermé hermétiquement dans un boîtier équipé de sorties parallèles prolongeant la carte mère.

Le montage de la figure 10 permet de disposer des micro-modules à un intervalle de 3 mm les uns des autres, ce qui permet de monter 16 micro-modules comportant des puces de 4 Mbits pour constituer un module mémoire de 0,5 Gbits dans un volume ne dépassant pas 35x65x34 mm.

## Revendications

1. Module de mémoire comprenant, sur un substrat (12) d'interconnexion, plusieurs puces de mémoire à semi-conducteurs ayant toutes la même forme allongée dont les connexions de sortie sont localisées aux extrémités petites, caractérisé en ce qu'il comporte au moins deux puces (14,16 ; 38,40) empilées et croisées de façon que les sorties d'une puce débordent de la puce placée sous elle dans l'empilement.

2. Module selon la revendication 1, caractérisé en ce que des composants annexes (22,24) tels que des condensateurs ou des circuits logiques intégrés, sont placés entre les branches de la croix constituée par deux puces (14,16) à 90°.

3. Module selon la revendication 1, caractérisé en ce qu'il comporte trois puces croisées à 60° les unes des autres ou quatre puces (14,16,26,28) à 45°.

4. Module selon la revendication 1, 2 ou 3, caractérisé en ce que des cales (20,30,32) sont placées sous les extrémités petites des puces en porte-à-faux.

5. Module de mémoire comprenant, sur un substrat (12) d'interconnexion, plusieurs puces de mémoire à semi-conducteurs de forme allongée dont les connexions de sortie sont localisées aux extrémités petites, chaque puce (38,40) ayant une longueur supérieure à deux fois sa largeur, caractérisé en ce qu'un couple de deux puces parallèles et identiques (38) est empilé et croisé à angle droit avec un autre couple de deux puces également parallèles et identiques (40).

6. Module selon l'une quelconque des revendications précédentes, caractérisé en ce que, sur un jeu d'au moins deux puces empilées et croisées est superposé un autre jeu d'au moins deux puces, des cales étant prévues pour éviter les portes-à-faux.

7. Module selon l'une quelconque des revendications précédentes, caractérisé en ce que le substrat (12) porte au moins un jeu de deux puces sur chaque face.

8. Module selon l'une quelconque des revendications précédentes, caractérisé en ce qu'il comprend un support (45) muni d'un bus (50) passant sous plusieurs substrats (12) et en ce que les substrats sont munis de moyens de liaison avec le bus.

9. Module selon la revendication 8, caractérisé en ce que chaque substrat porte des plots de sortie des puces sur un seul bord et en ce que lesdits plots de sortie sont reliés aux fils de bus par des fils soudés.

10. Dispositif de mémoire comprenant plusieurs modules de mémoire selon l'une quelconque des revendications précédentes, caractérisé en ce que les substrats des modules sont placés parallèlement les uns aux autres dans un cadre et munis sur un bord de pattes de sortie soudables à des zones de raccordement d'une carte mère placée au fond du cadre.

## Patentansprüche

1. Speichermodul, welches auf einem Verbindungs-Substrat (12) mehrere Halbleiterspeicherchips umfaßt, die alle die gleiche längliche Form aufweisen, deren Ausgangsanschlüsse entlang der kurzen Seiten angeordnet sind, **da****durch gekennzeichnet**, **daß** es mindestens zwei Chips (14, 16; 38,40) umfaßt, die übereinandergestapelt und gekreuzt in der Weise sind, daß die Ausgänge eines Chips über den Chip hinausreichen, der darunter in dem Stapel angeordnet ist.

2. Speichermodul nach Anspruch 1, **dadurch gekennzeichnet**, **daß** angefügte Komponenten (22,24), wie beispielsweise Kondensatoren oder integrierte logische Schaltkreise, zwischen den Armen des Kreuzes angeordnet sind, das durch zwei Chips (14,16) im 90° Winkel gebildet wird.

3. Speichermodul nach Anspruch 1, **dadurch gekennzeichnet**, **daß** es drei im 60° Winkel gekreuzte Chips oder vier Chips (14,16,26,28) im 45° Winkel umfaßt.

4. Speichermodul nach Anspruch 1, 2 oder 3, **dadurch ge****kennzeichnet**, **daß** Unterlagen (20,30,32) unter den herausstehenden, kurzen Seiten der Chips angeordnet sind.

5. Speichermodul mit mehreren Halbleiterspeicherchips auf einem Verbindungs-Substrat (12), die eine längliche Form aufweisen, deren Speicherausgänge an den kurzen Seiten angeordnet sind, wobei jeder Chip (38,40) eine Länge von mehr als dem Zweifachen seiner Breite aufweist, **dadurch gekennzeichnet**, **daß** ein Paar von zwei parallelen und identischen Chips (38) übereinandergestapelt und im rechten Winkel mit einem anderen Paar von zwei ebenfalls parallelen und identischen Chips (40) gekreuzt sind.

6. Speichermodul nach einem der vorangegangenen Ansprüche, **dadurch gekennzeichnet, daß** auf einem Satz von mindestens zwei übereinandergestapelten und gekreuzten Chips ein anderer Satz von mindestens zwei Chips überlagert ist, wobei Unterlagen vorgesehen sind, um ein Überhängen zu vermeiden.

7. Speichermodul nach einem der vorangegangenen Ansprüche, **dadurch gekennzeichnet, daß** das Substrat (12) mindestens einen Satz von zwei Chips auf jeder Seite aufweist.

8. Speichermodul nach einem der vorangegangenen Ansprüche, **dadurch gekennzeichnet, daß** es einen Träger (45) aufweist, der mit einem Bus (50) versehen ist, welcher unter mehreren Substraten (12) verläuft, und daß die Substrate mit einer Einrichtung zur Verbindung mit dem Bus versehen sind.

9. Speichermodul nach Anspruch 8, **dadurch gekennzeichnet,** **daß** jedes Substrat Ausgangskontakte der Chips auf einer einzigen Platte trägt, und daß die Ausgangskontakte mit Drähten des Busses durch gelötete Drähte verbunden sind.

10. Speichervorrichtung mit mehreren Speichermodulen nach einem der vorangegangenen Ansprüche, **dadurch gekenn****zeichnet, daß** die Substrate der Module parallel zueinander in einem Rahmen angeordnet und auf einem Brett mit lötbaren Anschlußklemmen vorgesehen sind, die mit Verbindungsbereichen einer Mutter-Karte lötbar sind, die am Boden des Rahmens vorgesehen ist.

## Claims

1. A memory module comprising, on an interconnection substrate (12), a plurality of semi-conductor memory chips having a same elongated shape and having output connections located at the smaller ends thereof,
characterized in that it comprises at least two chips (14,16; 38,40) stacked and crossed so that the output connections of one chip are beyond the periphery of the chip which is located under it in the stack.

2. Module according to claim 1,
characterized in that auxiliary components (22,24) such as capacitors or integrated logic circuits, are located between the arms of the cross constituted by two chips (14,16) at a 90° angle.

3. Module according to claim 1,
characterized in that it comprises three chips at mutual angles of 60° or four chips (14,16,26,28) at mutual angles of 45°.

4. Module according to claim 1, 2 or 3,
characterized in that supports (20,30,32) are located under the smaller ends of the cantilevered chips.

5. A memory module comprising, on an interconnection substrate (12), a plurality of semi-conductor memory chips of elongated shape whose output connections are located at the smaller ends thereof, each chip (38,40) having a length which is more than twice its width,
characterized in that a set of two mutually parallel and identical chips (38) is stacked and crossed at right angles with another set of two chips (40) which are also parallel and identical.

6. Module according to any one of the preceding claims,
characterized in that, on a set of at least two stacked and crossed chips, another set of at least two chips is superimposed, supports being provided for avoiding cantilever.

7. Module according to any one of the preceding claims,
characterized in that the substrate (12) carries at least one set of two chips on each face thereof.

8. Module according to any one of the preceding claims,
characterized in that it comprises a support (45) provided with a bus (50) passing under a plurality of substrates (12) and in that the substrates are provided with means for connection with the bus.

9. Module according to claim 8,
characterized in that each substrate carries chip output tabs on one edge only and in that said output tabs are connected to the bus conductors by welded wires.

10. Memory device comprising a plurality of memory modules according to any one of the preceding claims,
characterized in that the substrates of the modules are located in a frame in mutually parallel condition and are provided on an edge of output tabs weldable to connection zones of a mother board located at the bottom of the frame.
